**Europäisches Patentamt**

**European Patent Office**

**Office européen des brevets**

(19)

(11) Veröffentlichungsnummer: **0 200 958**
**B1**

(12) **EUROPÄISCHE PATENTSCHRIFT**

(45) Veröffentlichungstag der Patentschrift:
**11.10.89**

(51) Int. Cl.⁴: **G01R 33/035**, G01R 33/022

(21) Anmeldenummer: **86105134.0**

(22) Anmeldetag: **14.04.86**

(54) **Vorrichtung zur Messung schwacher Magnetfelder mit mehreren Gradiometern.**

(30) Priorität: **26.04.85 DE 3515199**

(43) Veröffentlichungstag der Anmeldung:
**17.12.86 Patentblatt 86/46**

(45) Bekanntmachung des Hinweises auf die Patenterteilung:
**11.10.89 Patentblatt 89/41**

(84) Benannte Vertragsstaaten:
**DE FR IT NL**

(56) Entgegenhaltungen:
**EP-A- 0 111 827**

**IEEE TRANSACTIONS ON MAGNETICS, Band MAG-11,
Nr. 2, März 1975, Seiten 778-781, IEEE, New York, US;
R.K. KIRSCHMAN et al.: "Advances in superconducting
quantum electronic microcircuit fabrication"
CRYOGENICS, Band 23, Nr. 5, Mai 1983, Seiten 263, 264,
Butterworth & Co. (Publishers) Ltd., Guildford, Surrey,
GB; S.I. BONDARENKO et al.: "A planar thin-film SQUID
of high inductive coupling constant"**

(73) Patentinhaber: **Siemens Aktiengesellschaft,
Wittelsbacherplatz 2, D-8000 München 2(DE)**

(72) Erfinder: **Hoenig, Eckhardt, Dr., Palmstrasse 1a,
D-8520 Erlangen(DE)**

ACTORUM AG

**Beschreibung**

Die Erfindung bezieht sich auf eine Vorrichtung zur Messung schwacher Magnetfelder mit mehreren Gradiometern, die mit ihren zugeordneten SQUIDs in einem Dewar-Gefäß angeordnet sind, das mit einem engen Hals versehen ist.

Es ist bekannt, zur Messung schwacher, sich ändernder Magnetfelder, beispielsweise in einem Feldstärkebereich unter $10^{-10}$ T, insbesondere unter $10^{-12}$ T, supraleitende Quanten-Interferenz-Elemente zu verwenden, die bekannt sind unter der Bezeichnung "SQUID" (superconducting quantum interference device). Diese Elemente werden vorzugsweise verwendet in der medizinischen Technik, insbesondere in der Magnetokardiographie, bei der Magnetfelder des Herzens in der Größenordnung von etwa 50 pT gemessen werden, sowie in der Magnetoenzephalographie, bei der Magnetfelder des Gehirns in der Größenordnung von etwa 0,1 pT zu messen sind. Die Vorrichtung besteht im wesentlichen aus einer Detektorspule, die zusammen mit einer Koppelspule einen Flußtransformator bildet. Dem SQUID ist zur Signalerfassung und -verarbeitung eine Elektronik zugeordnet. Da die zu messenden Magnetfelder bis zu sechs Größenordnungen kleiner sind als äußere Störfelder, sind entsprechende Abschirmungen erforderlich. Wegen seiner größeren Empfindlichkeit kann ein DC-SQUID (direct-current-SQUID) verwendet werden, das zwei Josephsonkontakte enthält. Die Detektorspule bildet mit einer zugeordneten Kompensationsspule ein sogenanntes Gradiometer. Mit Gradiometern nullter, erster oder höherer Ordnung kann das im Gradiometerbereich noch inhomogene biomagnetische Nahfeld selektiv erfaßt werden.

Um eine räumliche Feldverteilung zu erhalten, muß zeitlich nacheinander an verschiedenen Orten des zu untersuchenden Bereiches gemessen werden. Dann besteht aber die Schwierigkeit, daß über die dazu erforderliche Meßzeit die Kohärenz der Felddaten nicht mehr gegeben ist und sich außerdem klinisch unzumutbare Meßzeiten ergeben. Mit einer bekannten Vorrichtung, die mehrere parallele Meßkanäle mit jeweils einem RF-SQUID (radio frequency SQUID) enthält, kann zwar im Prinzip die Meßzeit verkürzt werden (Physica 107 B (1981), Seiten 29, 30 North Holland Publ. Comp.), ein Gradiometer-Array, dem wenigstens ein SQUID-Array zugeordnet ist, kann jedoch mit dieser Ausführungsform nicht hergestellt werden.

Die SQUIDs und ihre supraleitenden Komponenten werden während des Betriebes auf einer Temperatur von 4,2 K gehalten und sind zu diesem Zweck in flüssiges Helium eingetaucht. Der Zwischenraum zwischen den doppelten Wänden des Dewar-Gefäßes ist evakuiert und enthält abgasgekühlte Superisolation. Die Wärmezuführung von außen durch die Gefäßwände ist somit gering. Um lange Standzeiten von beispielsweise mehreren Wochen zu erreichen, muß aber die Wärmezufuhr durch den Hals des Dewar-Gefäßes begrenzt werden. Diese Dewar-Gefäße sind deshalb mit einem verhältnismäßig engen Hals mit integrierter Abgaskühlung versehen (Rev. Sci. Instrum. 53 (12), Dec. 1982, Seiten 1815 bis 1845).

Die Feldverteilung über einer größeren Fläche, beispielsweise bei der Magnetokardiographie, kann mit einem Gradiometer-Array ermittelt werden, das eine Vielzahl von Gradiometern, beispielsweise 50 oder mehr Gradiometer, enthält, die beispielsweise eine Matrix bilden und deren Detektorspulen in einer Ebene nebeneinander angeordnet sind. Ein derartiges Gradiometer-Array läßt sich aber nicht mehr durch den engen Hals in das Dewar-Gefäß einführen.

Der Erfindung liegt somit die Aufgabe zugrunde, eine Vorrichtung zur Messung schwacher Magnetfelder anzugeben, bei der einer Vielzahl von Gradiometern eine entsprechende Vielzahl von SQUIDs zugeordnet ist und die dennoch eine hohe Standzeit des Dewar-Gefäßes ermöglicht.

Die Erfindung beruht auf der Erkenntnis, daß eine Erweiterung des Halses des Dewar-Gefäßes nicht erforderlich ist, wenn die Gradiometerspulen des Gradiometer-Arrays am Boden des Dewar-Gefäßes einzeln einsetzbar sind, und sie besteht nun in den Merkmalen des Anspruchs 1. Die einzelnen Gradiometer mit verhältnismäßig geringer Ausdehnung werden einzeln nacheinander am Boden des Dewar-Gefäßes in entsprechende Halterungen eingesetzt. Dadurch entsteht ein Gradiometer-Array mit nahezu beliebig großer Ausdehnung. Die bei Raumtemperatur flexiblen Verbindungsleiter der Gradiometer werden mit der ihnen zugeordneten Gegensteckverbindung verbunden, die ebenfalls auf dem Boden des Dewar-Gefäßes abgestützt ist. Mit der Ausführung des SQUID-Arrays und seiner supraleitenden Verbindungen als Steckmodul kann nun das SQUID-Array mit dem ihm zugeordneten Vielfachstecker durch den Hals des Dewar-Gefäßes eingeführt und in die als "Steckdose" wirkende Gegensteckverbindung eingesteckt werden. Ein besonderer Vorteil dieser Ausführungsform besteht darin, daß Gradiometer für verschiedene Zwecke ausgewechselt werden können. Es kann beispielsweise ein ebenes Gradiometer-Array für die Magnetokardiographie ausgewechselt werden gegen ein gekrümmtes Gradiometer-Array, das für die Magnetoenzephalographie vorgesehen ist.

In einer besonders einfachen Ausführungsform der Vorrichtung kann die Steckverbindung aus konzentrischen Kontaktringen bestehen, die mit supraleitenden Federkontakten versehen sind, mit denen die Supraleiter verbunden werden. Die Federkontakte können in den zugeordneten Kontaktring lediglich eingehängt werden, beispielsweise in entsprechende Nuten.

Das SQUID-Array kann vorzugsweise aus DC-SQUIDs in Dünnfilmtechnik bestehen, von denen eine große Anzahl auf einem Substrat mit verhältnismäßig geringer Ausdehnung seiner Flachseiten angeordnet ist und kann mit seinem Vielfachstecker ohne Schwierigkeiten durch den engen Dewarhals eingeführt werden.

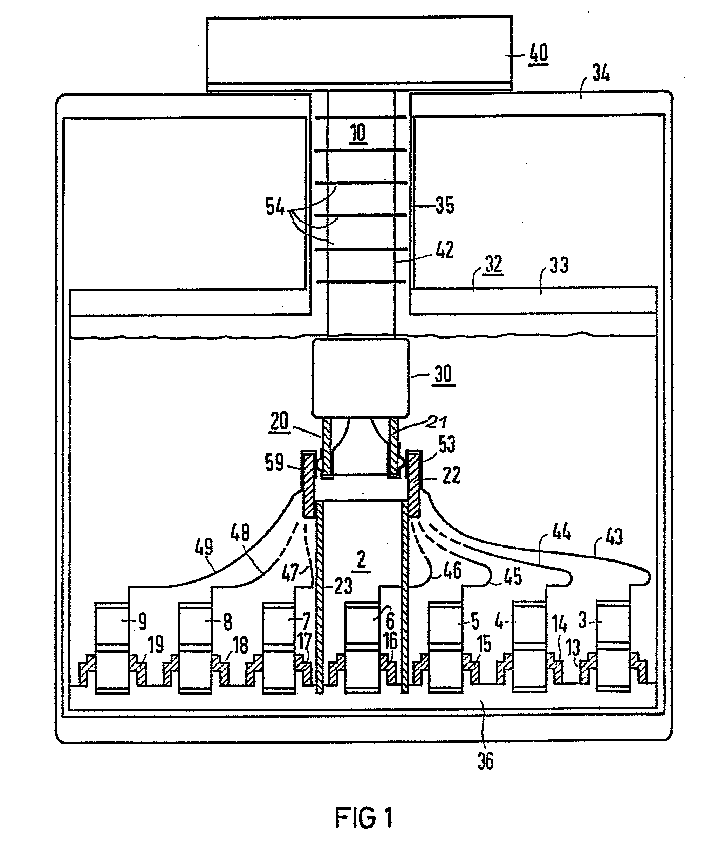

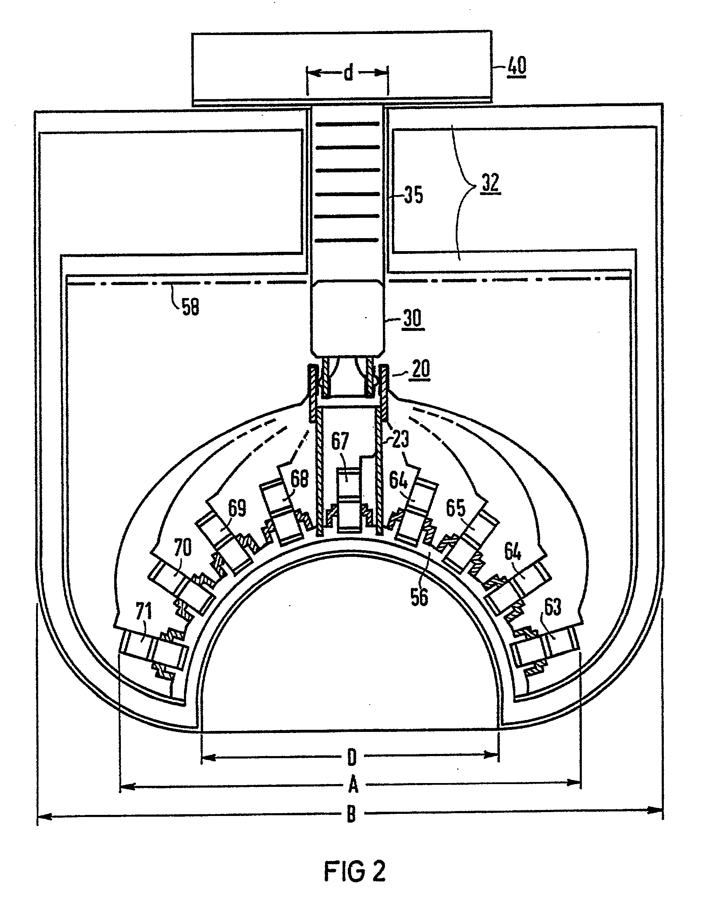

Zur weiteren Erläuterung der Erfindung wird auf die Zeichnung Bezug genommen, in deren Figuren 1 und 2 jeweils ein Ausführungsbeispiel einer Vorrichtung nach der Erfindung schematisch veranschaulicht ist.

In der Ausführungsform einer Vorrichtung zur Messung schwacher Magnetfelder nach Figur 1 ist ein Gradiometer-Array 2 vorgesehen, das eine Vielzahl von Gradiometern, beispielsweise wenigstens 30 Gradiometer, enthält, von denen in der Figur zur Vereinfachung nur 7 dargestellt und mit 3 bis 9 bezeichnet sind. Sie können beispielsweise Gradiometer zweiter Ordnung sein, deren nicht näher bezeichnete Detektorspulen in bekannter Weise mit ihren zugeordneten Kompensationsspulen in drei Ebenen übereinander angeordnet sind. Diese Gradiometer 3 bis 9 können jeweils in eine getrennte Halterung eingesetzt sein, die in der Figur mit 13 bis 19 bezeichnet sind. Diese Halterungen bestehen im wesentlichen aus einem Profilring aus formbeständigem Kunststoff, insbesondere Tetrafluoräthylen (Teflon), der bei Zimmertemperatur eine lockere Halterung bildet und sich bei Kryotemperatur derart zusammenzieht, daß er für das zugeordnete Gradiometer eine mechanisch feste Halterung bildet. Die Gradiometer 3 bis 9 sind mit ihrem unteren Ende, das die Detektorspule enthält, in eine entsprechende, in der Figur nicht näher bezeichnete Ausnehmung des Bodens 36 eines doppelwandigen Dewar-Gefäßes 32 eingesetzt, das mit einem verhältnismäßig engen Hals 35 versehen ist.

Der Raum zwischen den Gefäßwänden 33 und 34 ist in bekannter Weise evakuiert und enthält eine in der Figur nicht dargestellte Superisolation.

Zwischen dem Gradiometer-Array 2 und einem SQUID-Array 30 ist eine lösbare Leitungsverbindung vorgesehen, die als Steckverbindung 20 ausgeführt ist. Das SQUID-Array 30 mit einem Meßkopf 40 und einem Vielfachstecker 21 bilden einen Steckmodul 10. Das SQUID-Array 30 besteht aus DC-SQUIDs, denen der Meßkopf 40 zugeordnet ist, der die erforderliche Elektronik enthält.

Die DC-SQUIDs des SQUID-Arrays 30 können mit ihren beiden Josephson-Kontakten und ihren Koppelspulen sowie ihrer Modulationsspule vorzugsweise jeweils als Baueinheit in Dünnfilmtechnik hergestellt und auf einem gemeinsamen Halbleitersubstrat angeordnet sein, das vorzugsweise aus Silizium besteht. In dieser Ausführungsform der Baueinheiten als getrennte planare Dünnfilmstrukturen sind ihre elektrisch leitenden Teile jeweils durch elektrisch isolierende Zwischenlagen getrennt. Für die einzelnen DC-SQUIDs kann vorzugsweise noch eine zusätzliche magnetische Entkopplung vorgesehen sein, die aus einem supraleitenden Ring bestehen kann.

Zwischen dem SQUID-Array 30, das über eine mechanisch feste Halterung 42 mit dem Meßkopf 40 verbunden ist, und dem Gradiometer-Array 2 ist die Steckverbindung 20 angeordnet, deren Vielfachstecker 21 und Gegensteckverbindung 22 vorzugsweise aus konzentrischen Kontaktringen bestehen können, von denen einer am SQUID-Array 30 und der andere über eine mechanisch feste Halterung 23 am Boden 36 des Dewar-Gefäßes 32 befestigt ist.

Die elektrischen Zuleitungen zu den Gradiometern 3 bis 9 sind in der Figur mit 43 bis 49 bezeichnet. Die Ableitungen der Gradiometer 3 bis 9 sind in der Figur zur Vereinfachung nicht dargestellt. An der Gegensteckverbindung 22 ist für die Verbindungsleiter 43 bis 49 jeweils ein flaches supraleitendes Federelement vorgesehen, von denen in der Figur lediglich zwei als Schnitt schematisch angedeutet und mit 53 bzw. 59 bezeichnet sind und die in der praktischen Ausführungsform der Steckverbindung 20 beispielsweise jeweils in eine entsprechende Nut des Kontaktringes eingesetzt sein können. Diese Federelemente 53 und 59 können beispielsweise aus Niob bestehen oder mit Niob beschichtet sein. Als Verbindungsleiter 43 bis 49 sind beispielsweise Niobdrähte geeignet, die mit einem bei Raumtemperatur flexiblen und bei Helium-Temperatur starren Isolierschlauch versehen sind. Niob-Federelement und -Draht können durch Punktschweißen verbunden werden.

In einer besonders vorteilhaften Ausführungsform können die Verbindungsleiter als Folienleiter ausgeführt sein und aus einer supraleitenden Legierung, vorzugsweise Blei-Zinn, bestehen, die auf einen Träger angeordnet ist, der mit der Kunststoffolie verbunden ist. Als Träger kann beispielsweise Manganin oder auch Bronze vorgesehen sein. Diese Blei-Zinn-Legierung kann mit ihrem Träger als Mikrostruktur mit einer Dicke von wenigen µm, beispielsweise 10 µm, ausgeführt sein und kann mit den Federelementen 53 und 59 durch eine Lötverbindung verbunden werden. Die Verbindungsleiter des SQUID-Arrays 30 mit dem Meßkopf 40 sind in der Figur zur Vereinfachung nicht dargestellt. Der Hals 35 des Dewar-Gefäßes 32 enthält in bekannter Weise eine größere Anzahl von Strahlungsschilden 54. Diese Ausführungsform der Vorrichtung zur Messung schwacher Magnetfelder mit in einer Ebene nebeneinander angeordneten Detektorspulen der Gradiometer 3 bis 9 kann vorzugsweise verwendet werden in der Magnetokardiographie.

In der Ausführungsform einer Vorrichtung zur Messung schwacher Magnetfelder nach Figur 2 sind Gradiometer 63 bis 71 derart nebeneinander angeordnet, daß ihre in der Figur nicht dargestellten Detektorspulen in einer gekrümmten Fläche angeordnet sind, die beispielsweise etwa eine Kugelkalotte bildet, deren Durchmesser D beispielsweise etwa 20 cm betragen kann. Die gesamte Ausdehnung A des Gradiometer-Arays kann dann wenigstens 30 cm und der Außendurchmesser B des Dewar-Gefäßes 32 etwa 30 bis 40 cm betragen. Demgegenüber ist der Durchmesser d des Halses 35 des Dewar-Gefäßes 32 wesentlich geringer und wird im allgemeinen etwa 10 cm nicht wesentlich überschreiten. Das SQUID-Array 30 ist mit dem Vielfachstecker der Steckverbindung 20 und dem Meßkopf 40 als Steckmodul ausgebildet und wird durch den engen Hals 35 des Dewar-Gefäßes 32 eingeführt. die Halterung 23 für die Gegensteckverbindung der Steckverbindung 20 ist am gekrümmten Boden 56 des Dewar-Gefäßes 32 befestigt. Die Kälteabführung vom flüssigen Helium, dessen Spiegel in der Figur mit 58 bezeichnet ist, durch den Hals 35 des Dewar-Gefäßes 32 ist somit gering und die Standzeit der Vorrichtung entsprechend groß. Mit dieser Ausführungsform der Vorrichtung kann die gesamte Feldverteilung eines Meßobjekts mit gekrümmter Oberfläche, beispielsweise am Kopf eines Menschen, in einem gemeinsamen Arbeitsgang gemessen werden.

## Patentansprüche

1. Vorrichtung zur Messung schwacher Magnetfelder mit mehreren Gradiometern (3 bis 9 bzw. 63 bis 71), die mit ihren zugeordneten SQUIDs in einem Dewar-Gefäß (32) angeordnet sind, das mit einem engen Hals (35) versehen ist, **dadurch gekennzeichnet,** daß ein Gradiometer-Array (2) eine Vielzahl von am Boden (36) des Dewar-Gefäßes (32) einzeln montierbaren Gradiometern (3 bis 9 bzw. 63 bis 73) enthält, deren Detektorspulen nebeneinander angeordnet sind und die über eine supraleitende Steckverbindung (20) mit einem SQUID-Array (30) verbunden sind, das DC-SQUIDs enthält, denen ein Meßkopf (40) zugeordnet ist und daß das SQUID-Array (30) mit dem Meßkopf (40) und einem Vielfachstecker (21) als Steckmodul (10) ausgebildet ist und daß der Vielfachstecker (21) mit dem SQUID-Array (30) durch den Hals (35) des Dewar-Gefäßes (32) einführbar und in eine den Gradiometern (3 bis 9) zugeordnete Gegensteckverbindung (22) einsteckbar ist, die mit einer Halterung (23) am Boden (36) des Dewar-Gefäßes (32) befestigt ist.

2. Vorrichtung nach Anspruch 1, **dadurch gekennzeichnet,** daß die Gradiometer (63 bis 71) derart nebeneinander angeordnet sind, daß ihre Detektorspulen in einer gekrümmten Fläche angeordnet sind.

3. Vorrichtung nach Anspruch 1 oder 2, **dadurch gekennzeichnet,** daß der Vielfachstecker (21) und die Gegensteckverbindung (22) der Steckverbindung (20) als konzentrische Kontaktringe ausgebildet sind, von denen einer dem Gradiometer-Array (2) und der andere dem SQUID-Array (30) zugeordnet ist.

## Claims

1. Apparatus for measuring weak magnetic fields, having several gradiometers (3 to 9, or 63 to 71) which are arranged, with their associated SQUIDs, in a Dewar vessel (32) provided with a narrow neck (35), characterised in that a gradiometer array (2) comprises a plurality of gradiometers (3 to 9, or 63 to 71), which can be individually mounted on the floor (36) of the Dewar vessel (32), and the detector coils of which are arranged side by side, and which are connected by way of a superconducting plug connection (20) to a SQUID array (30) comprising DC SQUIDS having an associated measuring head (40), and in that the SQUID array (30), with the measuring head (40) and a multiple plug (21), is constructed as a plug module (10), and in that the multiple plug (21) with the SQUID array (30) can be introduced through the neck (35) of the Dewar vessel (32) and inserted into a matching plug connection (22), which is associated with the gradiometers (3 to 9), and which is attached to the floor (36) of the Dewar vessel (32) with a support (23).

2. Apparatus according to claim 1, characterised in that the gradiometers (63 to 71) are arranged side by side in such a way that their detector coils are arranged in a curved surface.

3. Apparatus according to claim 1 or 2, characterised in that the multiple plug (21) and the matching plug connection (22) of the plug connection (20) are constructed a concentric contact rings, one of which is associated with the gradiometer array (2), and the other with the SQUID array (30).

## Revendications

1. Dispositif pour la mesure de champs magnétiques faibles avec plusieurs gradiomètres (3 à 9; 63 à 71) qui sont disposés avec leurs SQUIDs associés dans un vase Dewar (32) qui est pourvu d'un col étroit (35), caractérisé par le fait qu'un arrangement de gradiomètres (2) comporte un grand nombre de gradiomètres (3 à 9; 63 à 71) susceptibles d'être montés individuellement dans le fond (36) du vase Dewar (32), alors que leurs bobines détectrices sont disposées les unes à côté des autres, et qui, par l'intermédiaire d'une liaison à enfichage (20), sont reliés avec un arrangement de SQUIDs (30) comportant des DC-SQUIDs auxquels est associée une tête de mesure (40), et que l'arrangement de SQUIDs, y compris la tête de mesure (40) et une fiche multibroches (21), est réalisé sous la forme d'un module à enfichage (10), et que la fiche multibroches (21), avec l'arrangement de SQUIDs (30), est susceptible d'être introduit à travers le col (35) du vase Dewar (32) pour être enfichée sur une liaison à enfichage antagoniste (22) qui est associée aux gradiomètres (3 à 9) et qui est fixée avec un support (32) au fond (36) du vase Dewar (32).

2. Dispositif selon la revendication 1, caractérisé par le fait que les gradiomètres (63 à 71) sont disposés de telle manière les uns à côté des autres que leurs bobines détectrices sont disposées dans une surface courbe.

3. Dispositif selon la revendication 1 ou 2, caractérisé par le fait que la fiche multibroches (21) et la liaison à enfichage antagoniste (22) de la liaison à enfichage (20) sont réalisées sous la forme d'anneaux de contact concentriques dont l'un est associé à l'arrangement des gradiomètres (2) et l'autre à l'arrangement de SQUIDs (30).

FIG 1

FIG 2